# EUROPEAN PATENT APPLICATION

(11) **EP 1 919 080 A1**
(43) Date of publication of application: **07.05.2008**
(21) Application number: 07112717.9
(22) Date of filing: 18.07.2007
(51) Int. Cl.: H03K 5/15, G06F 1/06, H03L 1/02

(54) **Integrated circuit system and control method thereof**

(30) Priority: 31.10.2006 KR 20060106657
(71) Applicant: SAMSUNG ELECTRONICS CO., LTD., Suwon-si, Gyeonggi-do (KR)
(72) Inventor: Ryu, Young-chan, Gyeonggi-do Suwon-si (KR)
(74) Representative: Waddington, Richard

(57) **Abstract**

An integrated circuit system and method are provided. The system includes a plurality of integrated circuits, ICs (210,220,230), which transmit and receive a data signal and a clock signal; a sensing part (240) which senses an environment of the integrated circuit system to generate environment data; and a control part (250) which adjusts a phase of at least one of the data signal and the clock signal, based on the environment data. The method includes sensing an environment of the integrated circuit system to generate environment data; and adjusting a phase of at least one of the data signal and the clock signal according to the environment data.

## Description

### BACKGROUND OF THE INVENTION

### Field of the Invention

Systems and methods consistent with the present invention relate to an integrated circuit system and a control method thereof, and more particularly, to an integrated circuit system which compensates for the displacement of a latch point, caused by high temperature, by using a pre-stored phase adjustment value, and a control method thereof.

### Description of the Related Art

Integrated circuit (IC) systems are complex technical electrical components or systems formed on a very small scale in which many electrical components are attached to, or integrally formed on, a single board.

Electronic apparatuses with advanced electrical techniques are experiencing trends of miniaturization and reduction in power, and the micromodule was developed in 1948 as a first stage of miniaturization. This forms an electrical circuit combining several sheets of transistors, diodes, resistors, and condensers attached with precision on a square ceramic separated board of roughly 8×8 mm².

ICs, developed with the object of enhancing the reliability and economy at the same time as further miniaturization as described above, can be divided into hybrid ICs and monolithic ICs. Hybrid ICs may be further divided into thin film hybrids and thick film hybrids. The main focus of recent development of integrated circuits has been on monolithic ICs, in which the electrical circuit is formed on a small, thin piece of silicon semiconductor, that is, a chip or die, with a thickness of 1 mm and a side length of 5 mm.

Communication methods between integrated circuits in a printed circuit board (PCB) include synchronous and asynchronous methods. The synchronous method is a method in which data is synchronized and input on the rising edge and falling edge of the clock signal, and the asynchronous method is a method in which data is input without regard to the clock signal. Each method has strengths and weaknesses, but the synchronous method, in which the input timing of data signals can be known exactly, is more widely used in the more rapidly moving semiconductor integrated circuits. Among synchronous methods, an I²C bus communication method, which uses two lines - a clock line (SCL) and a data line (SDA) - is regarded as superior to an SPI communication method, which uses three to four lines (SCLK, MISO, MOSI, SS), and the I²C bus communication method is thus more widely used.

Problems which can arise in PCBs include errors of a point latch due to external factors such as heat while IC transmission is in progress. Critical problems may arise such as a result system latch-up or malfunction.

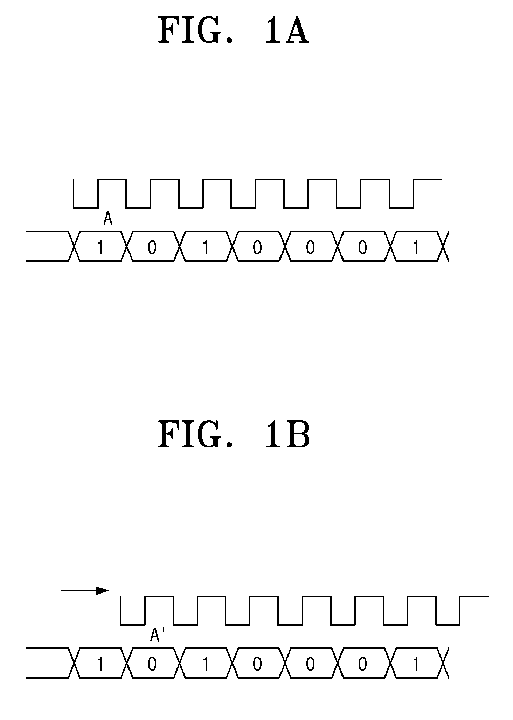

FIGS. 1A and 1B are drawings showing a latch point according to the related art. FIG. 1A shows a situation in which a latch point (A) is at a constant temperature, and FIG. 1B shows a situation in which a latch point (A') is moved by external factors such as heat.

Integrated circuit boards in current use not only latch data according to an incoming clock signal, but also set an optimum data latch point by slightly varying a position of the clocks. A comparison of FIGS. 1A and 1B illustrates compensation for a deviation of the latch point due to external factors.

However, in the related art, the latch point is slightly varied and the most appropriate latch point is set during the manufacture, which means that the set latch point can latch unintended data because the latch point continuously changes due to varying external factors including, mainly, temperature change due to the use of IC system

### SUMMARY OF THE INVENTION

Exemplary embodiments of the present invention overcome the above disadvantages and other disadvantages not described above. Also, the present invention is not required to overcome the disadvantages described above, and an exemplary embodiment of the present invention may not overcome any of the problems described above.

According to the present invention there is provided an apparatus and method as set forth in the appended claims. Other features of the invention will be apparent from the dependent claims, and the description which follows.

According to an aspect of the present invention, there is provided an integrated circuit system, comprising: a plurality of ICs which transmit and receive a data signal and a clock signal, a sensing part which senses environment data of the integrated circuit system, and a control part which adjusts a phase of at least one of the data signal and the clock signal, based on the sensed result.

The environment data may comprise temperature information of the integrated circuit system.

A storage part may be further provided, which stores a phase adjustment value corresponding to the environment data.

The control part may adjust latch points of the plurality of ICs, by adjusting the phase of at least one of the data signal and the clock signal, using the phase adjustment value stored in the storage part.

The plurality of ICs may each comprise a plurality of buffers, and a plurality of switches corresponding to each of the plurality of buffers, and the control part may adjust the phase of one of the data signal and the clock signal, by switching on or off the plurality of switches according to the sensed result.

According to another aspect of the present invention, there is provided a control method of an integrated circuit system which comprises a plurality of ICs to transmit and receive a data signal and a clock signal, the method comprising: sensing environment data of the integrated circuit system, and adjusting a phase of at least one of the data signal and the clock signal according to the sensed result.

The environment data may comprise temperature information of the integrated circuit system.

The adjusting the phase of at least one of the data signal and the clock signal may comprise detecting a phase adjustment value which corresponds to the sensed result, among phase adjustment values corresponding to the environment data.

The adjusting the phase of at least one of the data signal and the clock signal may also comprise adjusting latch points of the plurality of ICs, by adjusting a phase of at least one of the data signal and the clock signal using the detected phase adjustment value.

### BRIEF DESCRIPTION OF THE DRAWINGS

The above and other aspects of the present invention will become more apparent by describing in detail exemplary embodiments thereof with reference to the attached drawings, in which:

FIG. 1A and FIG. 1B are drawings showing a latch point according to the related art;

FIG. 2 is a block diagram showing a structure of an integrated circuit system according to an exemplary embodiment of the present invention;

FIG. 3 is a block diagram showing a structure of an integrated circuit system according to another exemplary embodiment of the present invention;

FIG. 4 is a diagram illustrating a phase adjustment value used in the integrated circuit system shown in FIG. 3;

FIGS. 5A and 5B are diagrams explaining a process in which the phase delayed by the integrated circuit system shown in FIG. 3 is compensated for, according to an exemplary embodiment of the present invention;

FIG. 6 is a block diagram showing in detail an internal structure of an IC inside the integrated circuit system shown in FIG. 3;

FIG. 7 is a flow chart explaining a control method of an integrated circuit system according to an exemplary embodiment of the present invention; and

FIG. 8 is a flow chart showing specifically the control method of the integrated circuit system of FIG. 7.

### DESCRIPTION OF EXEMPLARY EMBODIMENTS OF THE PRESENT INVENTION

The present invention provides an integrated circuit system and a control method thereof, which compensates for the displacement of a latch point, by using a phase adjustment value.

Hereinafter, aspects of the present inventive concept will be described in detail with reference to the drawings.

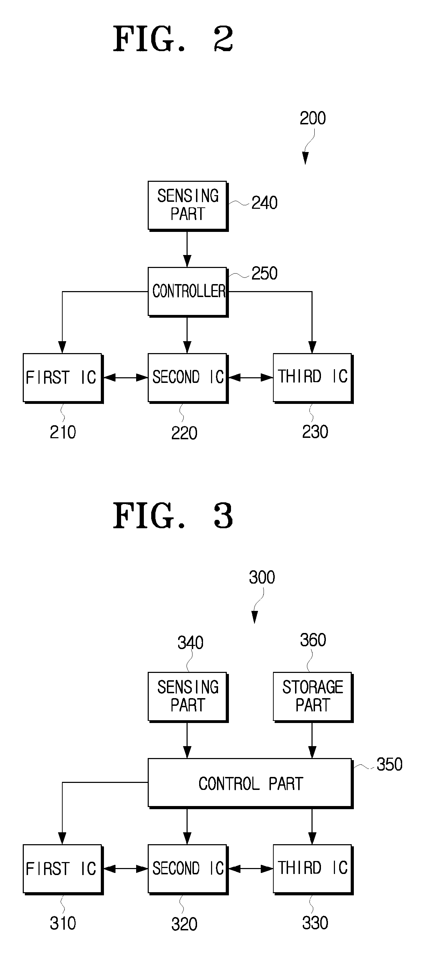

FIG. 2 is a block diagram showing a structure of an integrated circuit system according to an exemplary embodiment of the present invention. According to FIG. 2, the integrated circuit system 200 comprises a first IC 210, a second IC 220, a third IC 230, a sensing part 240 and a controller 250.

The first IC 210, the second IC 220, and the third IC 230 have a function of transmitting back and forth data signals and clock signals.

Respective ICs are generally formed with one transistor or tens or hundreds of transistors, resistors and condensers attached. ICs can be classified into analog ICs and digital ICs according to the type of transmission signal; into logical ICs, CPUs, memory ICs and switching ICs according to their use and function; and into TTL, MOS, C-MOS, hybrinic ICs, monolithic ICs, bipolar ICs and unipolar ICs according to their position and other factors. Also, they can be classified as SSI, MSI, LSI, and VLSI according to an integration size, and as DIP ICs, SIP ICs, and SMD ICs according to their mounting method.

Data communication between respective ICs in the integrated circuit system 200 is achieved using the inter-integrated circuit bus (I²C bus) communication method. The I²C bus is a synchronous two-way two-line bus using clock (SCL) and data (SDA) lines. A bus is a channel which transfers data between each component in a computer system. Each IC coupled to each respective bus has a unique address, and a master/slave relationship between each IC is materialized through this address. Each master and slave moves to a receiver and transmitter. The data transmission speed between each IC is capable of reaching 100 kbps in standard mode, and 400 kbps in fast mode.

As an example, in an integrated circuit system 200, if the first IC 210 operates a transmitter which transmits the data to the bus, the second IC 220 is able to operate a receiver which receives data from the bus. In this situation the first IC 210 transmits the clock signal and the data signal to the second IC 220 using a clock line and a data line respectively. At this time, a master/slave relationship develops between the first IC 210 and the second IC 220. That is, the first IC 210 initiates and finishes the creation and transfer of a start condition (i.e., a state in which the data line changes to low when the clock and the data are both in a general high state) and a finish condition (i.e., a state in which the data line changes from low to high when the clock is low), and generates the clock and transfers the slave address. Moreover, the first IC 210 determines the data transfer direction. When the first IC 210 sends the slave address, the second IC 220 compares the slave address with its own specific address and, if they are the same, sends a reply preserving the data as low in an acknowledge signal section. In this situation, the first IC 210 is able to read or use the data. Moreover, the same action is also able to arise between the second IC 220 and the third IC 230.

The first IC 210 is described above as a transmitter and the second IC 220 as a receiver, but in other exemplary embodiments, the second IC 220 may be a transmitter and the first IC 210 may be a receiver. Moreover, the number of ICs may be increased or decreased as needed.

The sensing part 240 senses environmental information of the integrated circuit system 200. Specifically, within the PCB, because the influence of temperature is greater than other influences, the sensing part 240 is able to sense temperature information of the integrated circuit system 200. In such a case the sensing part 240 denotes a temperature detector (not shown). In this situation, the sensing part 240 is disposed on part of an interior of the integrated circuit system 200, and it is advantageous that the sensing part 240 be disposed on a side of an IC up/down part. Moreover, the integrated circuit system 200 has been described above as having one sensing part 240, but it is also possible to have a plurality of sensing parts, with each IC having its own respective sensing part. Additionally, the environment information can include other information which has an influence on the operation of the integrated circuit system. For example, the environment information may include pressure and/or humidity.

The controller 250 adjusts a phase of at least one of the data signal and the clock signal based on the result of the sensing performed by the sensing part 240. As shown in FIGS. 1A and 1B, the latch point A of the clock signal is moved by a temperature change of the integrated circuit system 200. In this situation, the controller 250 is able to regulate the phase of the data signal and/or the clock signal by controlling a phase delay part (not shown) located on an interior of each of the first IC 210, the second IC 220, and the third IC 230. The regulation of the phase is explained below only with regard to the clock signal for ease of description. However, one having ordinary skill in the art will understand that the description below also applies to the regulation of the phase of the data signal.

The phase delay part (not shown) on each of the first IC 210, the second IC 220, and the third IC 230 is provided with a phase adjustment value, which corresponds to a temperature sensed by the sensing part 240, from a storage part (not shown) disposed on an interior of the controller 250, and delays the phase of the clock signal as according to the provided phase adjustment value. For example, the phase delay part may delay the phase of the clock signal by the phase adjustment value. The storage part (not shown) on the controller 250 measures and pre-stores the phase adjustment value corresponding to a temperature.

FIG. 3 is a block diagram showing the structure of an integrated circuit system according to another exemplary embodiment of the present invention. The integrated circuit system 300 in FIG. 3 comprises a first IC 310, a second IC 320, a third IC 330, a sensor 340, a controller 350 and a storage part 360. Among the components drawn in FIG. 3, detailed explanation is omitted regarding parts that are duplicates of parts shown in FIG. 2.

The storage part 360 stores a phase adjustment value according to the environment information of the integrated circuit system 300. The phase adjustment value may be preset. In contrast to FIG. 2, the storage part 360 of FIG. 3 may be configured as a separate memory. Specifically, the storage part 360 is able to store a phase adjustment value corresponding to the environmental state based on information such as the temperature, humidity and pressure.

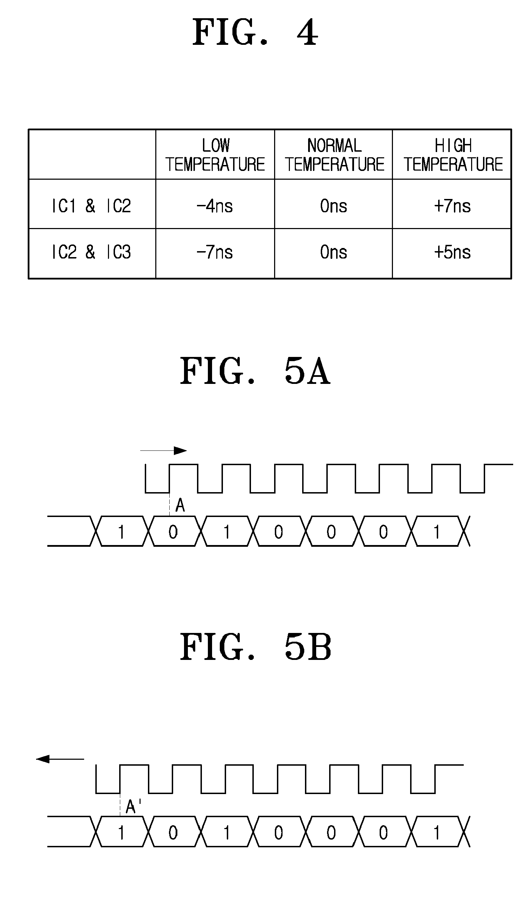

FIG. 4 is a drawing showing the data stored in the storage part 360, in an exemplary case in which the phase adjustment value adjusts for temperature of the integrated circuit system 300. As shown in FIG. 4, the phase adjustment value according to the temperature in the storage part 360 between the first IC 310 and the second IC 320, and between the second IC 320 and the third IC 330, is pre-set and stored. This is because the extent of the phase delay due to the temperature according to the movement characteristics of each IC. For example, in the case of high temperatures, the phase of the clock signal between the first IC 310 and the second IC 320 is delayed by as much as 7 ns, and the phase of the clock signal between the second IC 320 and the third IC 330 is delayed by as much as 5 ns. Here, the high temperature, low temperature and medium temperature are offered for convenience of explanation. The standard and extent of the temperature may be regulated appropriately according to necessity, and are able to measure and store the phase adjustment value according to a given value or range of values. In other words, high temperature may denote a specific temperature value, or may denote a range of temperature values, at which the delay a given value.

The controller 350 is able to regulate the latch point of the first IC 310, the second IC 320 and the third IC 330 by regulating the phase of one of the data signal and the clock signal using the phase adjustment value stored in the storage part 360.

The phase adjustment values used in FIGS. 2 and 3 can be stored on the storage part 360 according to test measurements performed in advance. For example, in the exemplary case of temperature, the integrated circuit system is held at a certain temperature and a phase difference between the clock signal and the data signal is detected and recorded. Then, the temperature is changed to a new temperature, and the phase difference is again measured and recorded. Accordingly, the phase adjustment value for preserving the detected phase adjustment difference can be stored corresponding to the temperature at the time.

In FIGS. 2 and 3, the stored phase adjustment value is used, but in the situation that a phase detection circuit (not shown) is provided, the phase adjustment value can be determined by the phase difference being directly detected. That is, when the detected temperature is compared with the preset temperature, in the situation that it is above or below a critical range, the phase can be adjusted based on a phase difference which is obtained by comparing the clock signal with a reference clock signal.

FIGS. 5A and 5B are drawings showing a situation in which the phase of the clock signal is delayed at high temperatures and a situation in which the delayed phase is compensated, respectively, according to an exemplary embodiment of the present invention.

FIG. 5A shows the situation in which the latch point A moves as much as 7 ns according to the phase delay of the clock signal resulting from a rise in temperature, and FIG. 5B shows the situation in which the latch point A' is adjusted using the stored and preset 7 ns phase adjustment value for high temperatures.

According to yet another exemplary embodiment of the present invention, the first IC, the second IC and the third IC may each comprise a plurality of buffers and a plurality of switches corresponding to a respective one of the plurality of buffers. Moreover, the controller 350 is able to mediate one phase among the data signals and clock signals by turning the plurality of switches on and off based on the result of sensing by the sensing part 340.

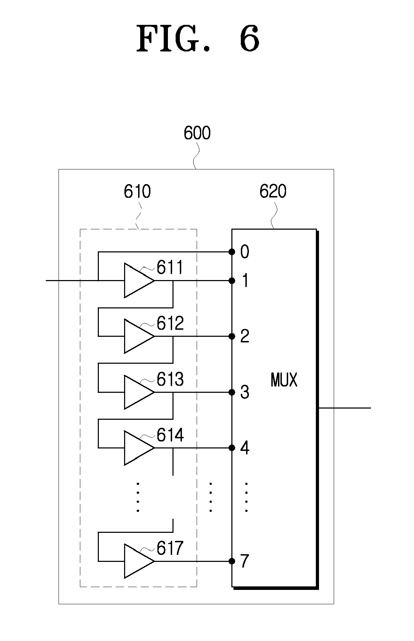

FIG. 6 is a block diagram schematically showing the composition of a phase extender disposed inside the IC of each integrated circuit system shown. As shown in FIG. 6, the phase extender 600 may comprise a buffer part 610 including a plurality of buffers 611 to 617, and a multiplexer (MUX) part 620 comprising a plurality of switches. The buffer part 610 with the plurality of buffers 611 to 617 operates to delay the phase of the clock signal, and the MUX part 620 selects a switch that corresponds to each of the buffers 611 to 617 to delay the phase according to a phase adjustment value, and accordingly adjusts the phase.

In an exemplary implementation, each of the buffers 611 to 617 may be configured to provide a delay of 0.1 ns. Accordingly, in an example (1) where a signal being output through the first buffer 611 is selected, the phase of the clock signal is delayed by 0.1 ns, and in an example (7) where a signal being output through the seventh buffer 317 is selected, the phase of the clock signal may be delayed by 0.7 ns. As a result, the displacement of the latch point by the temperature change, is adjusted by selecting an output of an appropriate buffer.

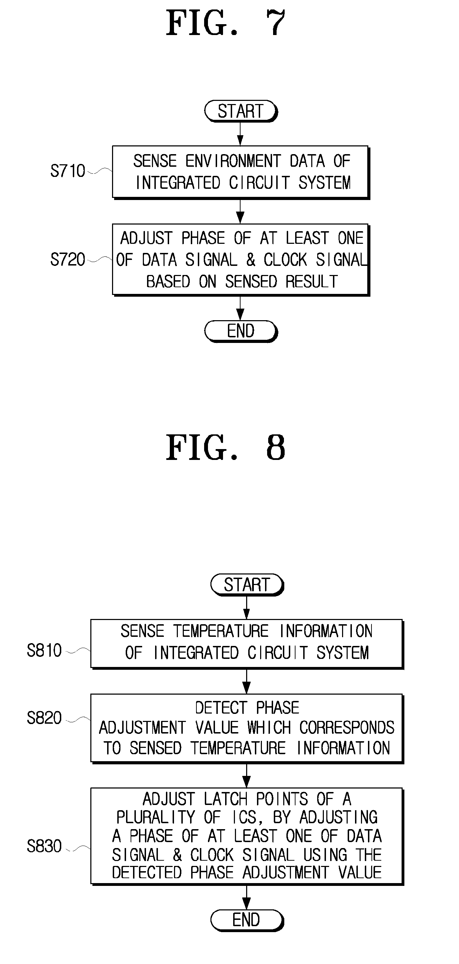

FIG. 7 is a flow chart explaining a control method of an integrated circuit system according to an exemplary embodiment of the present invention.

Referring to FIG. 7, environment data is sensed in an integrated circuit system which is equipped with a plurality of ICs to transmit and receive data signal and clock signal (S710). According to the sensed result, the phase of at least one of the data signal and the clock signal is adjusted (operation S720). The environment data may include temperature information.

FIG. 8 is a flow chart explaining specifically the control method of the integrated circuit system of FIG. 7.

Referring to FIG. 8, environment data is sensed in an integrated circuit system which is equipped with a plurality of ICs to transmit and receive data signal and clock signal (S810). A phase adjustment value, which corresponds to the sensed temperature information, is detected (S820). The phase adjustment value may be predetermined. The latch points of the plurality of ICs are then adjusted, by adjusting the phase of at least one of the data signal and the clock signal, using the detected phase adjustment value (S830).

Because the latch point is adjusted using a phase adjustment value, phase delay of the signal can be compensated with accuracy.

As explained above, with the exemplary embodiments of the present invention, the latch point is adjusted by using a phase adjustment value, and therefore, problems of the integrated circuit system, such as latch-up or malfunction, can be prevented.

The foregoing exemplary embodiments and advantages are merely exemplary and are not to be construed as limiting the present invention. The present teaching can be readily applied to other types of apparatuses. Also, the description of the exemplary embodiments of the present invention is intended to be illustrative, and not to limit the scope of the claims, and many alternatives, modifications, and variations will be apparent to those skilled in the art.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An integrated circuit system, comprising:
a plurality of integrated circuits, ICs, (210,220,230) which transmit and receive a data signal and a clock signal;
a sensing part (240) which senses an environment of the integrated circuit system to generate environment data; and
a control part (250) which adjusts a phase of at least one of the data signal and the clock signal, based on the environment data.

2. The system of claim 1, wherein the environment data comprises temperature information of the integrated circuit system.

3. The system of claim 1 or claim 2, further comprising a storage part which stores a phase adjustment value corresponding to the environment data,
wherein the control part (250) adjusts latch points of the plurality of ICs (210,220,230), by adjusting the phase of at least one of the data signal and the clock signal based on the phase adjustment value stored in the storage part.

4. The system of claim 3, wherein each of the plurality of ICs (210,220,230) comprises a plurality of buffers, and a plurality of switches corresponding to the plurality of buffers, and
the control part (250) adjusts the phase of one of the data signal and the clock signal, by switching on or off the plurality of switches according to the environment data.

5. A control method of an integrated circuit system which comprises a plurality of integrated circuits, ICs (210,220,230), to transmit and receive a data signal and a clock signal, the method comprising:
sensing an environment of the integrated circuit system to generate environment data; and
adjusting a phase of at least one of the data signal and the clock signal according to the environment data.

6. The control method of claim 5, wherein the environment data comprises temperature information of the integrated circuit system.

7. The control method of claim 5, wherein the adjusting the phase of at least one of the data signal and the clock signal comprises:
detecting a phase adjustment value which corresponds to the environment data, among phase adjustment values corresponding to the environment data; and
adjusting latch points of the plurality of ICs (210,220,230), by adjusting a phase of at least one of the data signal and the clock signal using the detected phase adjustment value.
